# EUROPÄISCHE PATENTSCHRIFT

(11) **EP 2 166 622 B1**
(45) Veröffentlichungstag und Bekanntmachung des Hinweises auf die Patenterteilung: **01.06.2016**
(21) Anmeldenummer: 09169717.7
(22) Anmeldetag: 08.09.2009
(51) Int. Cl.: H01R 13/11, H01R 13/52, H01R 13/66, H01L 31/048, H01L 31/02, H01R 12/71, H02S 40/34

(54) **Elektrische Anschlussvorrichtung für Flachleiter**
Electric connection device for flat conductors
Dispositif de raccordement électrique pour conducteurs plats

(30) Priorität: 22.09.2008 DE 202008012585 U; 17.06.2009 DE 202009004930 U
(43) Veröffentlichungstag der Anmeldung: 24.03.2010
(73) Patentinhaber: Weidmüller Interface GmbH & Co. KG, 32758 Detmold (DE)
(72) Erfinder: Beck, Thorsten, 34454, Bad Arolsen-Wetterburg (DE); Holterhoff, Klaus, 57462, Olpe (DE); Bönsch, Matthias, 33659, Bielefeld (DE); Püschner, Klaus, 32760, Detmold (DE); Wuensche, Torsten, 33818, Leopoldshöhe (DE)
(74) Vertreter: Dantz, Jan Henning

(56) Entgegenhaltungen:
- WO-A2-2007/118798
- DE-A1- 3 843 664
- DE-U1- 20 005 129
- DE-U1-202008 006 117
- US-B1- 7 114 971

## Beschreibung

Die Erfindung betrifft eine Anschlußvorrichtung für Leiterenden, insbesondere Flachleiterenden oder Messerkontakte, an Photovoltaikanlagen nach dem Oberbegriff des Anspruchs 1.

Photovoltaikanlagen weisen in der Regel wenigstens ein Photovoltaikpaneel zur Stromerzeugung aus Sonnenlicht auf. Dabei sind Leiterenden, in der Regel flexible Flachleiterenden, aus den Photovoltaikpaneelen herausgeführt, die es ermöglichen, die Photovoltaikpaneele - in der Regel über ein Mehrleiterkabel - beispielsweise an eine Hausinstallation oder zunächst an elektrische Geräte wie einen Wechselrichter oder dgl. anzuschließen.

Dabei ist es der Stand der Technik, die einzelnen Flachleiter mittels Einzelklemmen oder dgl. von Hand zu kontaktieren. Aus diesem Grund ist der Anschluss der Geräte relativ mühsam und es ist in der Regel notwendig, zum Anschluss der Geräte besonders geschulte Fachkräfte einzusetzen.

Ergänzend besteht das Problem, dass die derart erstellten Installationen in der Regel relativ unübersichtlich sind und von daher im Störungsfall auch nur schwer instand zu setzen sind.

Es sind auch Anschlussvorrichtungen mit einem Aufnahmegehäuse für die Flachleiterenden bekannt, mit welchen die Leiterenden kontaktiert werden (DE 20 2005 018 884 U1). Zum Stand der Technik werden ferner die US 4,460232 und die DE 203 11 183 U1 genannt.

Aus der gattungsgemäßen WO2007/118798A2 ist ferner eine Anschlussvorrichtung für Leiterenden, insbesondere Flachleiterenden an einem Photovoltaikpaneel bekannt, aus dem eine Mehrzahl der Flachleiterenden vorsteht, und die ein Aufnahmegehäuse aufweist sowie eine auf dem Photovoltaikpaneel anbringbare, insbesondere auf dieses aufklebbaxe Aufnahmeeinheit zur Aufnahme der Flachleiterenden, auf welche das Aufnahmegehäuse aufsetzbar ist. Dabei ist die Aufnahmeeinheit als Aufnahmeträger ausgebildet, der wenigstens eine Aufnahme oder eine Mehrzahl von Aufnahmen, insbesondere Aufnahmestegen aufweist, über die jeweils eines der Flachleiterenden biegbar ist, die in dieser Position von Tulpenkontakten kontaktierbar sind, welche bei der Stromerzeugung jeweils Strom leitende Elemente darstellen. Fallweise wird vorgeschlagen, dass Aufnahmegehäuse mit einem separaten Deckel auszustatten und in das Aufnahmegehäuse elektronische Funktionselemente, wie z.B. Dioden zu integrieren. Aus der DE 20 2008 006 117 U1 ist es bekannt, in den Deckel Funktionselemente wie ein Kühlblech und eine Diode zu integrieren.

Diese Art der Kontaktierung der WO2007/118798A2 hat sich zwar an sich bewährt.

Es ist aber gewünscht, die Handhabung für den Wartungsfall zu vereinfachen.

Es ist somit die Aufgabe der Erfindung, eine Anschlußvorrichtung für Flachleiterenden an Photovoltaikanlagen zu schaffen, deren Handhabung im Wartungsfall vereinfacht ist. Es soll im Wartungsfall das Öffnen des Aufnahmegehäuses gestattet sein, ohne dass die Leiterenden im Wartungsfall beschädigt werden.

Die Erfindung löst diese Aufgabe durch den Gegenstand des Anspruchs 1.

Da das Grundteil auf dem Photovoltaikpaneel verbleibt, muß es im Servicefall nicht wieder umständlich von diesem gelöst werden. Es ist vielmehr lediglich notwendig, das Deckelteil vom Grundteil abzunehmen, indem eine Verrastung und/oder Verschraubung oder eine sonstige Verriegelung zwischen diesen Elementen gelöst wird und es kann dann das Deckelteil komplett mit einer Leiterplatte insbesondere mit Dioden und ggf. sonstigen Komponenten getauscht werden.

Optimierungsbedarf besteht weiter in Hinsicht auf die Gefahr beim Wartungsfall, dass die Leiterenden im Wartungsfall beschädigt werden. Die Gefahr soll verringert werden.

Es verbleiben die Anschlusskontakte beim Abnehmen des Deckelteils vom Grundteil am Leiterende - insbesondere am Flachleiterende - in kontaktierter Stellung, so dass die Gefahr von Störungen bei der Wartung gering gehalten ist, wohingegen die Elektronikschaltung - insbesondere eine Leiterplatte mit Dioden - mit dem Deckelteil als Einheit von dem Grundteil abnehmbar und auswechselbar ist. Derart wird eine einfache und sichere Wartung der Anschlussvorrichtung - insbesondere in Hinsicht auf die Elektronik - sichergestellt.

Vorteilhafte Ausgestaltungen sind den Unteransprüchen zu entnehmen.

Nachfolgend wird die Erfindung unter Bezug auf die Zeichnung anhand eines Ausführungsbeispiels näher beschrieben. Es zeigt:
- Fig. 1: eine perspektivische Ansichten eines Bereiches eines Photovoltaikpaneels und eine als Montagerahmen ausgebildete Aufnahmeeinheit vor dem Aufsetzen auf das Photovoltaikpaneel;
- Fig. 2: die Anordnung aus Fig. 1 in geschnittener perspektivischer Darstellung;
- Fig. 3: eine perspektivische Ansicht eines Anschlussgehäuses vor dem Aufsetzen auf den auf das Photovoltaikpaneel aufgesetzten Montagerahmen mit darauf aufgebogenen Leiterenden;
- Fig. 4: die Anordnung aus Fig. 3 in geschnittener perspektivischer Darstellung;
- Fig. 5: das Anschlussgehäuse nach dem Aufsetzen auf den auf das Photovoltaikpaneel aufgesetzten Montagerahmen;
- Fig. 6: die Anordnung aus Fig. 5 in geschnittener perspektivischer Darstellung und eine Ausschnittsvergrößerung eines Teilbereiches;
- Fig. 7: das Anschlussgehäuse nach einem Abnehmen von dem auf das Photovoltaikpaneel aufgesetzten Montagerahmen;
- Fig. 8a-c: die Anordnung aus Fig. 7 in geschnittener perspektivischer Darstellung und Ausschnittsvergrößerungen von Teilbereichen dieser Anordnung; und
- Fig. 9a: eine perspektivische Ansicht einer weiteren als Montagerahmen ausgebildeten Aufnahmeeinheit vor dem Aufsetzen auf das Photovoltaikpaneel;
- Fig. 9b: eine perspektivische Ansicht eines Anschlussgehäuses vor dem Aufsetzen auf den Montagerahmen aus Fig. 9a;
- Fig. 9c: das Anschlussgehäuse nach dem Aufsetzen auf den Montagerahmen aus Fig. 9a;
- Fig. 9d: die Anordnung aus Fig. 9c nach dem Abnehmen eines Deckelteils;
- Fig. 9e: die nach dem Abnehmen des Deckelteils auf einem Photovoltaikpaneel verbleibende Anordnung.

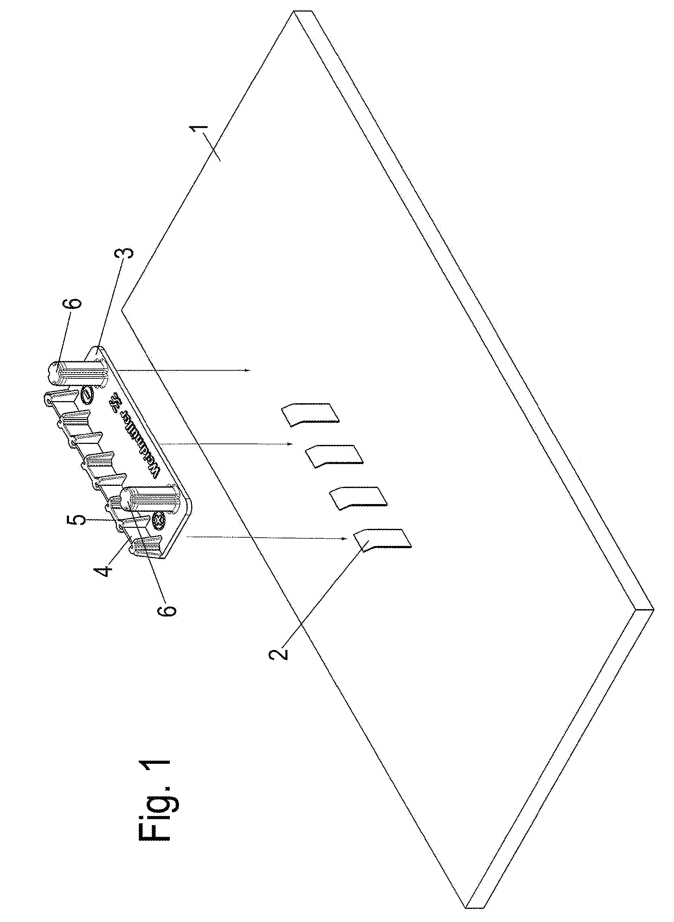

Fig. 1 zeigt ein Photovoltaikpaneel 1, aus dem eine Mehrzahl von vorzugsweise flexiblen, biegbaren Flachleiterenden 2 vorsteht, die hier in bevorzugter, aber nicht zwingender Ausgestaltung, parallel zueinander in einer Reihe ausgerichtet sind und deren Endabschnitte vom Photovoltaikpaneel 1 senkrecht nach oben vorstehen, insbesondere oben umgebogen sind.

Diese Flachleiterenden 2 sind mit einer Anschlussvorrichtung zu kontaktieren. Dies geschieht an einem Aufnahmeträger 3 für die Leiterenden 2. Dieser wird vorzugsweise einfach und schnell mittels eines Doppelklebebandes an der Rückseite des Photovoltaikpaneels befestigt.

Der Aufnahmeträger 3 weist eine Reihe von Aufnahmestegen 4 auf, die im montierten Zustand vorzugsweise senkrecht zur Oberfläche des Photovoltaikpaneels ausgerichtet sind und über die jeweils hier von der Seite des Montagerahmens her eines der Flachleiterenden 2 biegbar ist, um an den Aufnahmestegen 4 stabile Kontaktbereiche auszubilden. Die Aufnahmestege 4 selbst dienen hier aber nicht der Stromleitung sondern nur der mechanischen Aufnahme der Flachleiterenden.

Die Aufnahmestege 4 sind hier jeweils beidseits von Trennwänden/Trennstegen 5 begrenzt, die senkrecht zu den Aufnahmestegen 4 ausgerichtet sind, so dass die Aufnahmestege 4 für die einzelnen Flachleiterenden 2 klar voneinander getrennt sind, was es ermöglicht, Fehlbeschaltungen zu vermeiden.

Die Aufnahmestege 4 können aus Kunststoff oder einem anderen Material, ggf. auch Metall, bestehen. Sie können theoretisch nahezu beliebig relativ zueinander ausgerichtet sein, so in einer oder mehreren Reihen nebeneinander oder parallel zueinander oder beispielsweise auch derart, dass sie gemeinsam auf einem Bogen liegen.

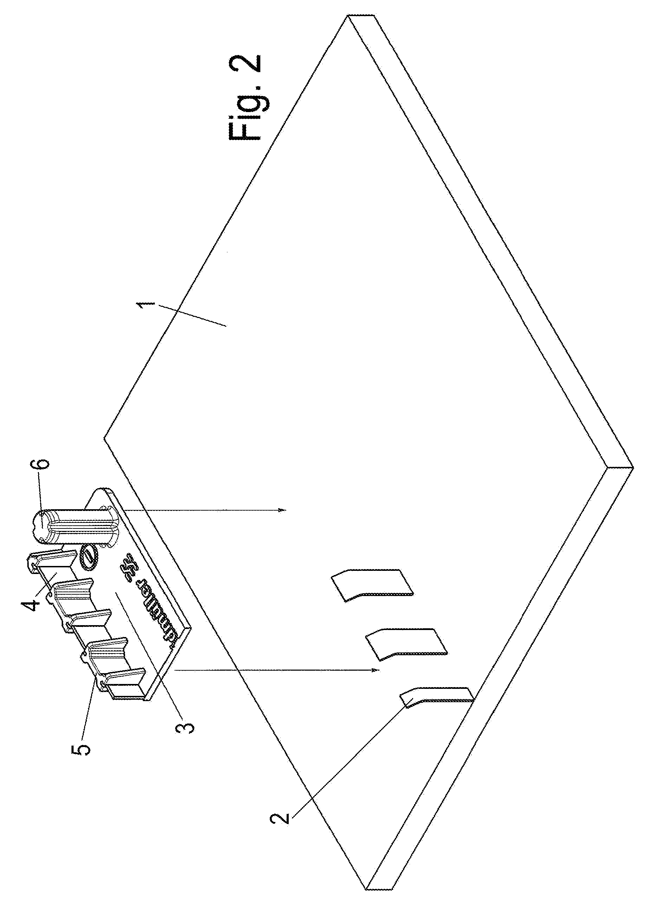

Seitlich der jeweils äußersten Trennwände 5 sind hier größere Vorzentrierungsstege 6 ausgebildet (Fig. 2), die eine Vorzentrierung und Führung eines nachfolgend noch zu erläuternden Aufnahmegehäuses beim Aufsetzen auf den Aufnahmeträger gewährleisten und die damit auch als Fehlsteckschutz dienen. Das Aufnahmegehäuse weist korrespondierende Aufnahmen auf, in welche die Vorzentrierungsstege eingreifen (hier nicht dargestellt)

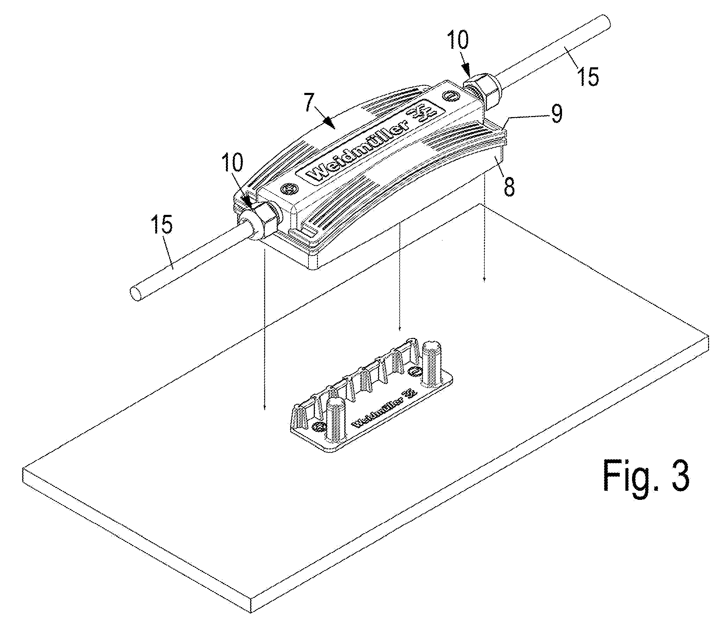

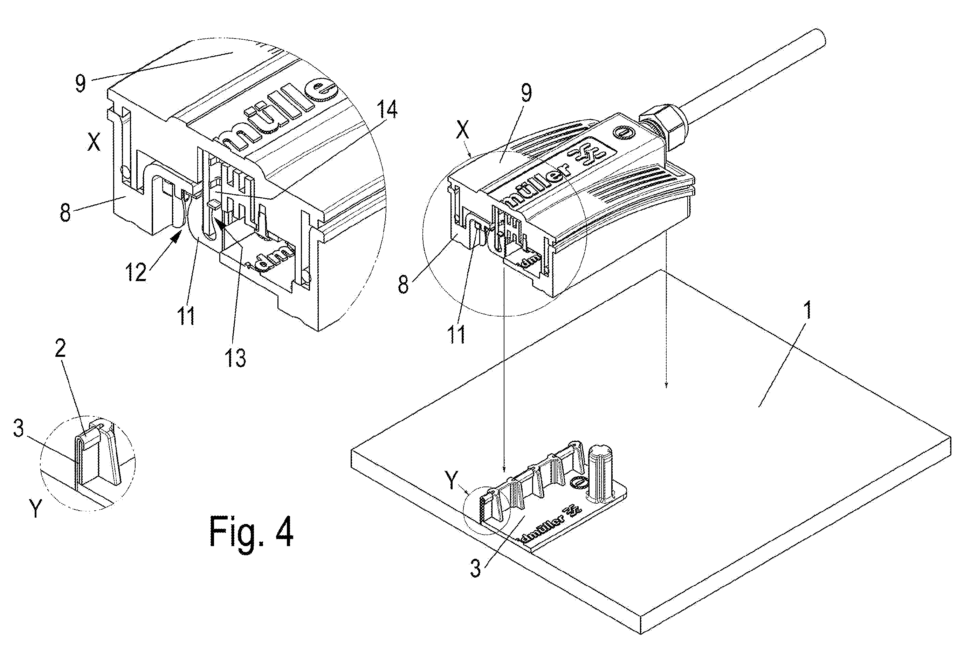

Auf den Aufnahmeträger 3 ist ein Anschluss- und Aufnahmegehäuse 7 mit einer Mehrzahl von Anschlusskontakten für die Flachleiterenden aufsetzbar, insbesondere aufsteckbar (Fig. 3,4).

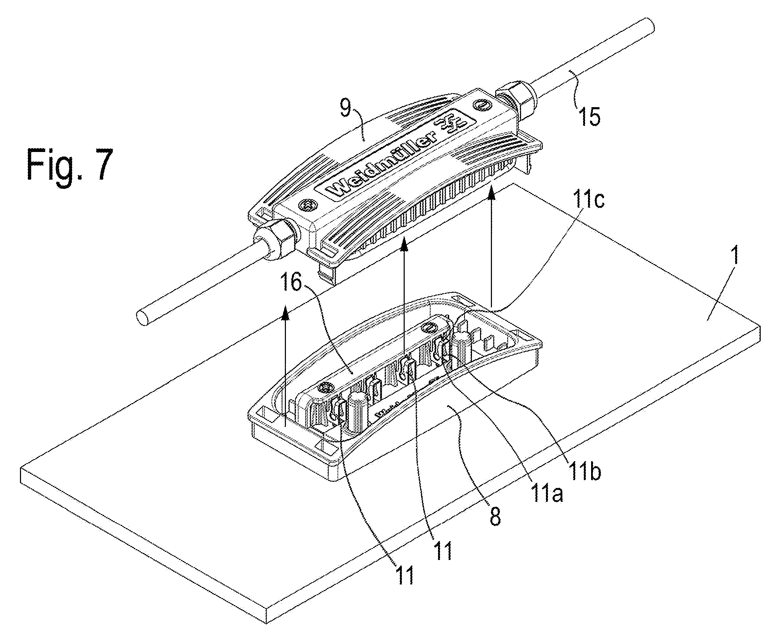

Das Anschlussgehäuse 7 ist - siehe auch Fig. 7 - mehrteilig mit Grundteil 8 und Deckelteil 9 ausgebildet, die in nachfolgend noch näher zu beschreibender Weise vormontiert miteinander verbunden sind. Das Anschlussgehäuse 7 weist ferner - hier an den Seiten - Durchführungen 10 auf, die zum Beispiel zur Durchführung von Kabeln 15 - insbesondere mit einer PG-Verschraubung geeignet sind. Alternativ können hier auch Steckvorrichtungen realisiert werden, die zum Anschluss von Kabeln mit korrespondierenden Kupplungen oder direkt zum Anschluss weiterer Aufnahmegehäuse nutzbar sind.

Das Grundteil 8 und das Deckelteil 9 können auch schwenkbar miteinander verbunden und zum Schließen miteinander verrastbar sein.

Das Anschlussgehäuse 7 ist mit Anschlusskontakten, hier mit tulpenartig zu den Aufnahmestegen hin offenen, stromleitenden Federkontakten 11, versehen, die dazu dienen, beim Aufsetzen des Anschlussgehäuses 7 auf den Aufnahmeträger 3 die auf die Aufnahmestege 4 gebogenen Flachleiterenden 2 zu kontaktieren und die derart ausgelegt und/oder angeordnet sind, dass so starke Federkräfte wirken, dass ein sicherer leitender Kontakt zu den Flachleiterenden 2 sichergestellt wird.

Hier sind die Federkontakte 11 ferner in bevorzugter Ausgestaltung als Doppelkontakte S-förmig ausgelegt und bilden quasi eine Art Doppel-Federkontakt aus, wobei mit dem einen dieser Federkontaktbereiche 12 nach unten zum Photovoltaikpaneel hin die Flachleiterenden 2 kontaktiert werden und wobei mit dem anderen Federkontaktbereich 13, der relativ zu dem ersten Federkontaktbereich 12 zur entgegen gesetzten Seite hin offen steht, hier ein Leiterplattenrand-Kontaktbereich einer Leiterplatte 14 kontaktiert wird.

Die Federkontakte 11 sind über die Leiterplatte 14 miteinander leitend verschaltet, wobei die Leiterplatte vorzugsweise mit elektrischen/elektronischen Bauelementen wie Dioden versehen kann. Die Leiterplatte 14 wird ferner - beispielsweise mittels weiteren hier nicht dargestellten Anschlusskontakten oder aber lötend - von Leitern der Kabel 15 kontaktiert. Diese Kabel 15 können auch vorkonfektioniert an das Anschlussgehäuse angeschlossen sein.

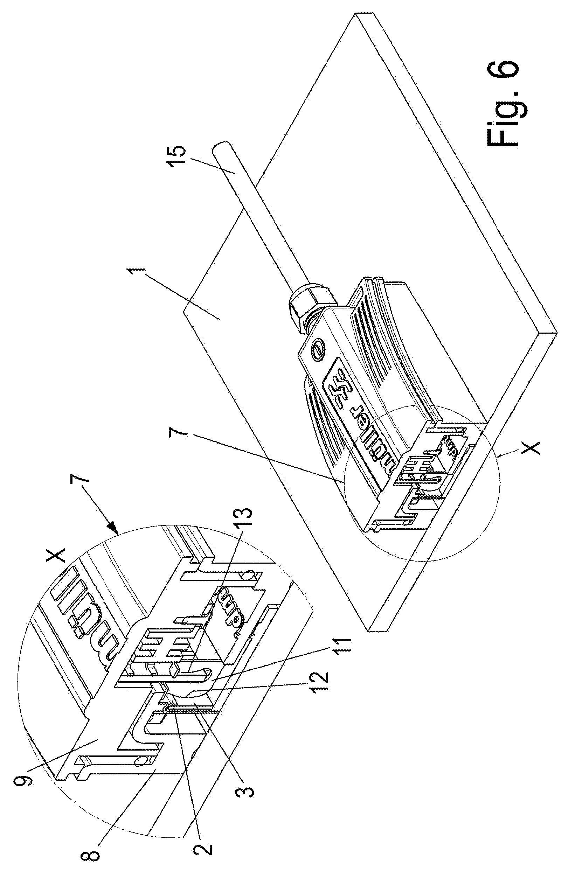

Das Aufnahmegehäuse 7 mit dem Grundteil 8 und dem Deckelteil bildet eine im montierten Zustand geschlossene, aber durch das Abnehmen des Deckelteils 9 zu öffnende Wanne (bis auf Öffnungen für die Kabeldurchführungen), so dass die inneren Bestandteile des Aufnahmegehäuses 7 geschützt werden. Am auf dem Photovoltaikpaneel aufliegenden Rand kann eine umlaufende Dichtung ausgebildet sein. Das Anschlussgehäuse kann klebend am Photovoltaikpaneel festgelegt sein. Auch das Grundteil 8 und das Deckelteil 9 werden vorzugsweise gegeneinander durch eine umlaufende Dichtung abgedichtet (siehe Fig. 4 und 6).

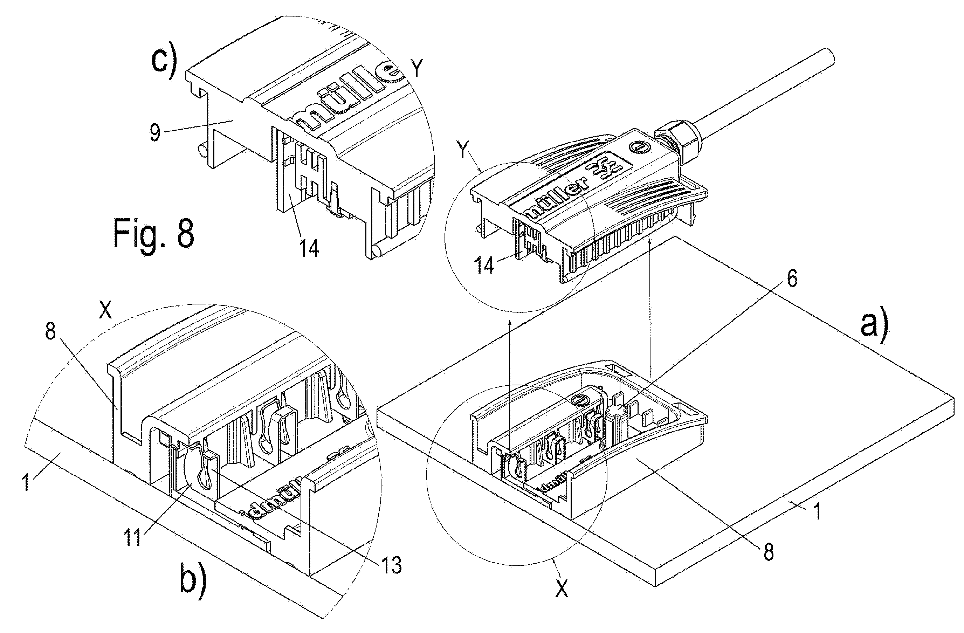

Wie aus Fig. 6 und Fig. 8 ersichtlich, ist die Leiterplatte 14 am Deckel 9 festgelegt (z.B. festgeklemmt oder festgeklebt), während die S-förmigen Federkontakte 11 am Grundteil 8 festgelegt sind, was hier mit Hilfe eines Niederhaltesteges 16 realisiert ist.

Das Deckelteil 9 und das Grundteil sind lösbar miteinander verbunden, was hier in bevorzugter Ausgestaltung mit Hilfe korrespondierender Rastmittel 17, 18 am Deckelteil 9 und am Grundteil 8 realisiert wird. Vorzugsweise ist die Ausgestaltung derart, dass das Deckelteil 9 und das Grundteil 8 werksseitig vormontiert und bevorzugt sogar mit Kabeln vorkonfektioniert geliefert werden.

Das Lösen des Deckelteils 9 kann dagegen vorzugsweise nicht werkzeuglos sondern nur mit einem Werkzeug wie einem Schraubendreher erfolgen. Alternativ ist es auch denkbar, das lösbare Verbinden des Deckelteils 9 mit dem Grundteil 8 mit Hilfe einer Schraubverbindung zu realisieren.

Diese Ausgestaltung hat zur Folge, dass beim Lösen des Deckelteils 9 dieses Deckelteil 9 mitsamt der Leiterplatte 14 aus den Federkontakten 11 gezogen wird, während die Federkontakte 11 an sich mitsamt dem Grundteil 8 am Photovoltaikpaneel 1 verbleiben.

Im Fehlerfall wird einfach das Deckelteil 9 mitsamt der Leiterplatte 14 abgenommen und gegen ein anderes Deckelteil 9 mit Leiterplatte 14 getauscht. Dabei verbleibt das Grundteil 8 mitsamt der Federkontakte 11 am Photovoltaikpaneel.

Damit ist ein Austausch der Leiterplatte 14 möglich, ohne das es notwendig ist, den Kontakt zwischen den Flachleiterenden und den Federkontakte 11 wieder zu lösen. Beschädigungen dieses Kontaktbereiches im Wartungsfall werden derart auf einfache Weise vermieden.

Aus Fig. 7 ergibt sich noch, dass die Federkontakte 7 hier als Stanz-/Biegeteile gefertigt sind, die zwei zueinander parallele S-Kontaktplatten 11a, 11b aufweisen, welche über einer Steg 11c miteinander verbunden sind, was den Kontakt einfach herstellbar, aber dennoch stabil macht.

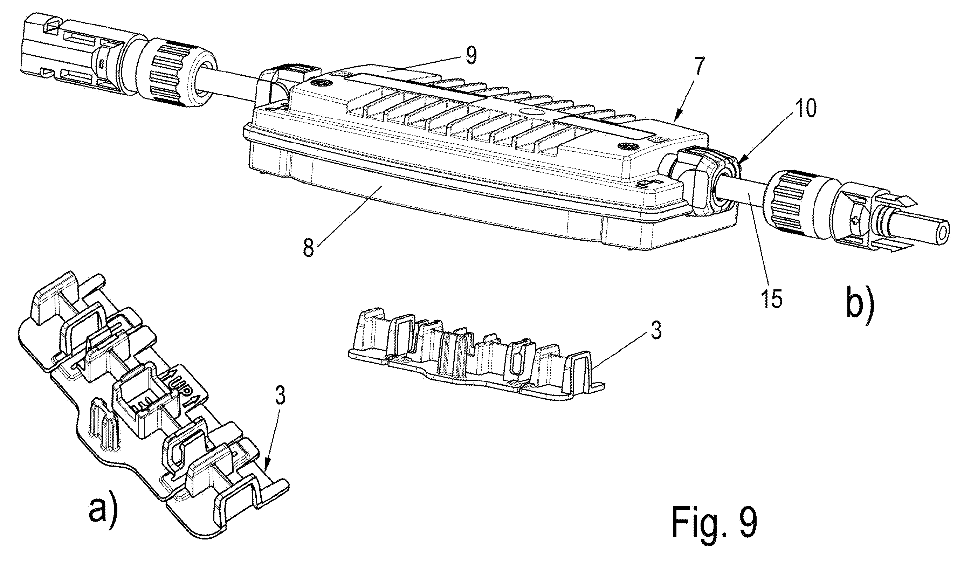

Eine weitere Variante der Erfindung ist in Fig. 9a bis Fig. 9e dargestellt. Der Einfachheit halber ist das Photovoltaikpaneel in diesen Fig. nicht dargestellt. Fig. 9a zeigt eine perspektivische Ansicht einer weiteren als Montagerahmen ausgebildeten Aufnahmeeinheit 3 in einem aufgesetzten Zustand ohne Darstellung des Photovoltaikpaneels.

Fig. 9b zeigt eine perspektivische Ansicht eines Anschlussgehäuses vor dem Aufsetzen auf den Montagerahmen aus Fig. 9a;

Auf den Aufnahmeträger bzw. die Aufnahmeeinheit 3 ist wiederum ein Anschluss- und Aufnahmegehäuse 7 mit einer Mehrzahl von Anschlusskontakten für die Flachleiterenden aufsetzbar, insbesondere aufsteckbar.

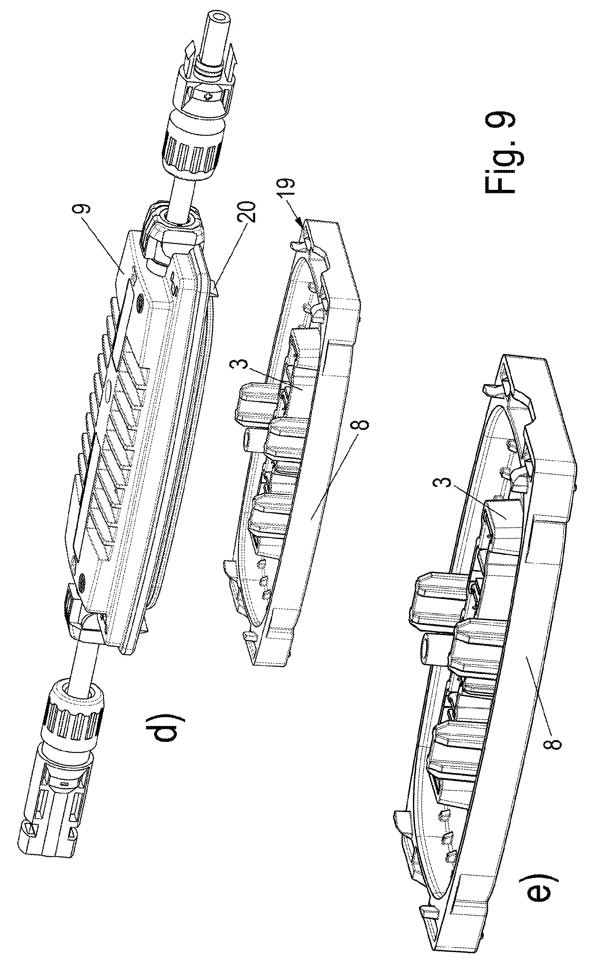

Das Anschlussgehäuse 7 ist - siehe auch Fig. 9d - wiederum mehrteilig mit Grundteil 8 und Deckelteil 9 ausgebildet. Diese beiden Elemente sind miteinander verbindbar, beispielsweise an korrespondierenden Rastmitteln 19, 20 miteinander verrastbar oder miteinander verschraubbar.

Das Anschlussgehäuse 7 weist wiederum Durchführungen 10 auf, die zum Beispiel zur Durchführung von Kabeln 15 - insbesondere mit einer PG-Verschraubung geeignet sind. Alternativ können hier auch wiederum Steckvorrichtungen realisiert werden, die zum Anschluss von Kabeln mit korrespondierenden Kupplungen oder direkt zum Anschluss weiterer Aufnahmegehäuse nutzbar sind.

Das Anschlussgehäuse 7 ist auch wiederum mit hier nicht dargestellten Anschlusskontakten, hier mit tulpenartig zu den Aufnahmestegen hin offenen, stromleitenden Federkontakten, versehen, die dazu dienen, beim Aufsetzen des Anschlussgehäuses 7 auf den Aufnahmeträger 3 die auf die Aufnahmestege 4 gebogenen Flachleiterenden 2 zu kontaktieren und die derart ausgelegt und/oder angeordnet sind, dass so starke Federkräfte wirken, dass ein sicherer leitender Kontakt zu den Flachleiterenden 2 sichergestellt wird.

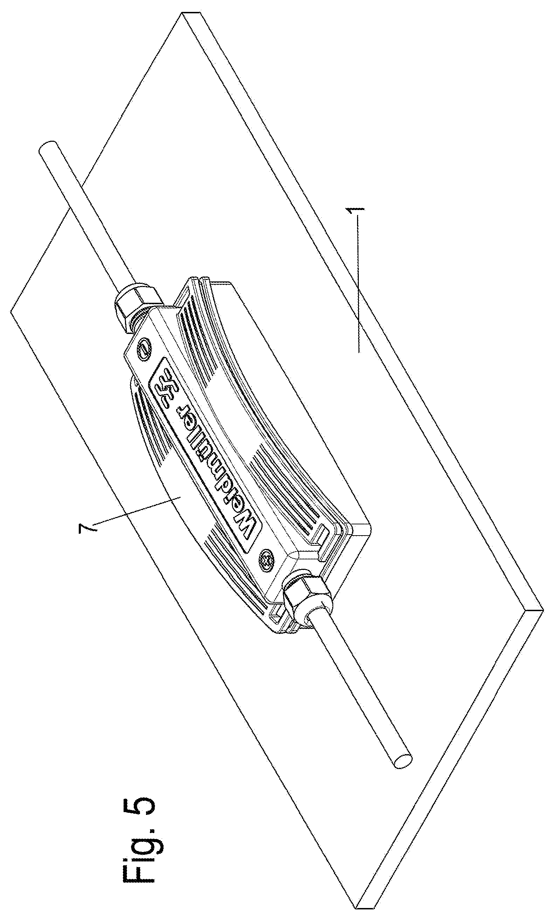

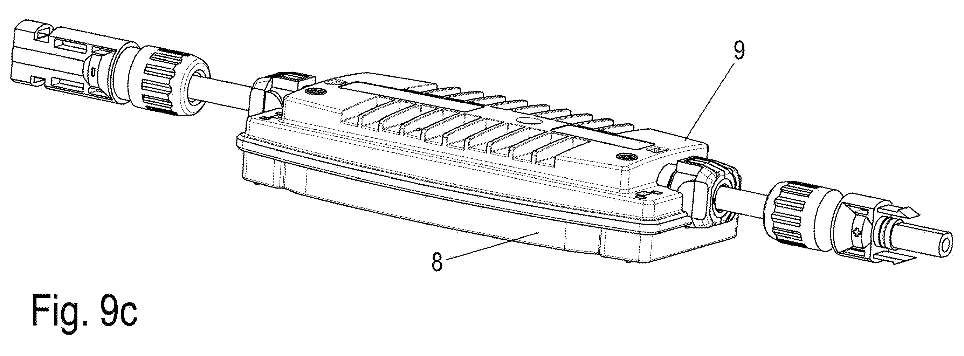

Anders als nach Fig. 1 bis 8 ist es bei dem in Fig. 9 dargestellten Ausführungsbeispiel aber vorgesehen, dass zwar nach einem Aufsetzen des Anschlussgehäuses auf das Photovoltaikpaneel das Grundteil 8 auf dem Photovoltaikpaneel verbleibt, nicht aber die Kontakte zum Kontaktieren der Flachleiterenden. Die Leiterplatte 14 wird vielmehr z.B. im Servicefall zusammen mit dem Deckelteil 9 und den Kontakten zum Kontaktieren der Flachleiterenden von dem Grundteil 8 abgenommen. In das Deckelteil 9 kann z.B. auch ein Wechselrichter integriert werden.

Dies hat den Vorteil, dass die Leiterplatte zusammen mit dem Deckelteil 9 gewechselt werden kann. Im Servicefall wird sie einfach mit ausgetauscht.

Auf dem Photovoltaikpaneel verbleiben im Servicefall die Aufnahmeeinheit 3 mit den Anschlüssen zum Photovoltaikpaneel, insbesondere mit den auf den Aufnahmeträger aufgebogenen Flachleiterenden, und das Grundteil 8. Die (vorzugsweise "Feder")-Kontakte des Anschlussgehäuses 7 zu den Flachleiterenden 2 werden aber nach dieser Variante wieder mit von den Flachleiterenden abgenommen.

### Bezugszeichen

- Photovoltaikpaneel: 1
- Flachleiterenden: 2
- Aufnahmeträger: 3
- Aufnahmestege: 4
- Trennwände/Trennstege: 5
- Vorzentrierungsstege: 6
- Anschlussgehäuse: 7
- Grundteil: 8
- Deckelteil: 9
- Durchführungen: 10
- Federkontakte: 11
- Kontaktplattenbereiche: 11a,b
- Stegbereich: 11c
- Federkontaktbereiche: 12, 13
- Leiterplatte: 14
- Kabel: 15
- Niederhaltesteg: 16
- Rastmittel: 17, 18

## Patentansprüche

1. Anschlussvorrichtung für Leiterenden, die Flachleiterenden (2) sind, an einem Photovoltaikpaneel (1), aus dem eine Mehrzahl der Leiterenden (2) vorsteht, und die
a. ein Anschlussgehäuse (7) mit einer in dem Anschlussgehäuse (7) aufgenommenen Elektronikschaltung aufweist und
b. eine auf dem Photovoltaikpaneel anbringbare, insbesondere aufklebbare Aufnahmeeinheit (3) zur Aufnahme der Leiterenden (2), auf welche das Anschlussgehäuse (7) aufsetzbar ist,
c. wobei das Anschlussgehäuse (7) mit Anschlusskontakten (11) versehen ist und
d. wobei die Flachleiterenden mittels der stromleitenden Anschlusskontakte (11) kontaktierbar sind,
e. wobei die Aufnahmeeinheit als Aufnahmeträger (3) ausgebildet ist, der wenigstens eine Aufnahme oder eine Mehrzahl von Aufnahmen, insbesondere Aufnahmestegen (4) aufweist, über die jeweils eines der Flachleiterenden (2) biegbar ist und wobei das Anschlussgehäuse (7) auf den Aufnahmeträger (3) aufsteckbar, so beispielsweise aufrastbar, ist, wozu es eine jedenfalls abschnittsweise offene Bodenseite aufweist, so dass es über den Aufnahmeträger (3) setzbar ist, und
f. wobei das Anschlussgehäuse (7) ein Grundteil (8) und ein Deckelteil (9) aufweist **gekennzeichnet durch** eine am Deckelteil (9) festgelegte Elektronikschaltung, die als Einheit zusammen mit dem Deckelteil (9) vom Grundteil (8) abnehmbar ist,
g. wobei das Anschlussgehäuse (7) mit tulpenartig zu den Aufnahmestegen hin offenen Federkontakten (11) als Anschlusskontakten versehen ist, die dazu dienen, beim Aufsetzen des Anschlussgehäuses (7) auf den Aufnahmeträger (3) die auf die Aufnahmestege (4) gebogenen Flachleiterenden (2) zu kontaktieren, **dadurch** gekennzeichnet,
h. dass die Anschlusskontakte (11) ferner derart ausgelegt und angeordnet sind, dass sie beim Abnehmen des Deckelteils vom Grundteil im die Leiterenden kontaktierenden Zustand am Photovoltaikpaneel verbleiben, und
i. dass die Anschlusskontakte (11) als Doppelkontakte mit gegensinniger Kontaktierungsrichtung ausgebildet sind.

2. Anschlussvorrichtung für Flachleiterenden nach Anspruch 1, **dadurch gekennzeichnet, dass** die Federkontakte (11) in bevorzugter Ausgestaltung S-förmig ausgelegt sind und einen Doppel-Federkontakt ausbilden, der zwei zu voneinander abgewandten Seiten hin offene Federkontaktbereiche (12, 13) aufweist.

3. Anschlussvorrichtung nach Anspruch 2, **dadurch gekennzeichnet, dass** mit dem einen der Federkontaktbereiche (12) zum Photovoltaikpaneel hin die Flachleiterenden (2) kontaktierbar sind und dass mit dem anderen Federkontaktbereich (13), der zur relativ zu dem ersten Federkontaktbereich (12) entgegengesetzten Seite hin offen steht, die Elektronikschaltung, vorzugsweise ein Leiterplattenrandbereich einer Leiterplatte (14) kontaktierbar ist.

4. Anschlussvorrichtung für Flachleiterenden nach Anspruch 3, **dadurch gekennzeichnet, dass** die Leiterplatte (14) am Deckel (9) festgelegt ist, während die S-förmigen Federkontakte (11) am Grundteil (8) festgelegt sind.

5. Anschlussvorrichtung für Flachleiterenden nach einem der Ansprüche 3 oder 4, **dadurch gekennzeichnet, dass** die S-förmigen Federkontakte (11) am Grundteil (8) mit Hilfe eines Niederhaltesteges (16) festgelegt sind, so dass beim Lösen des Deckelteils (9) dieses Deckelteil (9) mitsamt der Leiterplatte (14) aus den Federkontakten (11) gezogen wird, während die Federkontakte (11) mit dem Grundteil (8) am Photovoltaikpaneel (1) verbleiben.

6. Anschlussvorrichtung für Flachleiterenden nach einem der Ansprüche 4 bis 5, **gekennzeichnet durch** eine Auslegung derart, dass ein Austausch der Leiterplatte (14) mitsamt Deckelteil (9) möglich ist, ohne das es notwendig ist, den Kontakt zwischen den Flachleiterenden (2) und den Federkontakte (11) wieder zu lösen.

7. Anschlussvorrichtung nach einem der vorstehenden Ansprüche, **dadurch gekennzeichnet, dass** am Anschlussgehäuse (7) seitliche Durchführungen (14) für Kabel oder für Steckvorrichtungen (15) ausgebildet sind.

8. Anschlussvorrichtung nach einem der vorstehenden Ansprüche, **dadurch gekennzeichnet, dass** das Grundteil (8) und das Deckelteil (9) miteinander lösbar verbunden sind.

9. Anschlussvorrichtung nach Anspruch 8, **dadurch gekennzeichnet, dass** das Grundteil (8) und das Deckelteil (9) miteinander mittels Rastmitteln lösbar verbunden sind.

10. Anschlussvorrichtung nach Anspruch 9, **dadurch gekennzeichnet, dass** das Grundteil (8) und das Deckelteil (9) miteinander mittels Schraubmitteln lösbar verbunden sind.

11. Anschlussvorrichtung nach einem der vorstehenden Ansprüche, **dadurch gekennzeichnet, dass** elektrische und/oder elektronische Bauelemente wie Dioden auf der Leiterplatte (14) angeordnet sind.

12. Anschlussvorrichtung für Flachleiterenden nach Anspruch 1, **dadurch gekennzeichnet, dass** die Kontakte zur Kontaktierung der Flachleiterenden mit dem Deckelteil (9) von dem Grundteil und der Aufnahmeeinheit (3) abnehmbar sind.

## Claims

1. A connection device for conductor ends, which are flat conductor ends (2), on a photovoltaic panel (1), out of which protrude a plurality of conductor ends (2), and which
a) has a connection housing (7) with an electronic circuit that is received in the connection housing (7), and
b) a receiving unit (3) which can be attached to the photovoltaic panel and especially glued on it for the purpose of receiving the conductor ends (2) upon which the connection housing (7) can be placed,
c) wherein the connection housing (7) is provided with connection contacts (11), and
d) wherein the flat connector ends can be contacted by means of the current-conducting connection contacts (11),
e) wherein the receiving unit is formed as a receiving carrier (3), which has at least one seat or a multitude of seats, in particular receiving bridges (4), via which one of the flat conductor ends (2) can be bent, and wherein the connection housing (7) can be inserted into the receiving carrier (3), e.g. it can be latched thereon, for which purpose it comprises at any rate a sectionally open bottom side so that it can be placed over the receiving carrier (3), and
f) wherein the connection housing (7) has a base part (8) and a lid part (9), **characterized by** an electronic circuit, fixed to the lid part 9, which can be removed as a unit from the base part (8) together with lid part (9),
g) wherein the connection housing (7) is provided with spring-finger contacts (11) as connection contacts that are open in bell fashion toward the receiving bridges, said contacts being used for the purpose of contacting the flat conductor ends (2) that are bent up upon the receiving bridges (4) as the connection housing (7) is placed upon the receiving carrier (3),
**characterized in that**
h) the connection contacts (11) are further formed and arranged that during the removal of the lid part from the base part said connection contacts will remain in the state on the photovoltaic panel where they contact the conductor ends, and
i) the connection contacts (11) are formed as double contacts with opposite contacting direction.

2. A connection device for conductor ends according to claim 1, **characterized in that** the spring-finger contacts (11) are designed in a preferred embodiment in an S-shaped manner and form a double spring-finger contact that comprises two spring-finger contact areas (12, 13) that are open toward sides that face away from each other.

3. A connection device according to claim 2, **characterized in that** the flat conductor ends (2) can be contacted with the one of the spring-finger contact areas (12) toward the photovoltaic panel and that, with the other spring-finger contact area (13) that is open toward the side that is opposite relative to the first spring-finger contact area (12), the electronic circuit, preferably a printed circuit board edge area of a printed circuit board (14), can be contacted.

4. A connection device for flat conductor ends according to claim 3, **characterized in that** the printed circuit board (14) is fixed to the lid (9), while the S-shaped, spring-finger contacts (11) are fixed to the base part (8).

5. A connection device for flat conductor ends according to one of the claims 3 or 4, **characterized in that** the S-shaped, spring-finger contacts (11) are fixed to the base part (8) by means of a down-holding bridge (16) so that during the release of the lid part (9), said lid part (9), together with printed circuit board (14), will be pulled out of the spring-finger contacts (11), while the spring-finger contacts (11) remain on the photovoltaic panel (1) with the base part (8).

6. A connection device for flat conductor ends according to one of the claims 4 to 5, **characterized by** a configuration such that an exchange of the printed circuit board (14), together with lid part (9), is possible without any need for again releasing the contact between the flat conductor ends (2) and the spring-finger contacts (11).

7. A connection device according to one of the above claims, **characterized in that** lateral passages (14) for cables or for plug-in devices (15) are formed on the connection housing (7).

8. A connection device according to one of the above claims, **characterized in that** the base part (8) and the lid part (9) are separably connected to each other.

9. A connection device according to claim 8, **characterized in that** the base part (8) and the lid part (9) are separably connected to each other by latching means.

10. A connection device according to claim 9, **characterized in that** the base part (8) and the lid part (9) are separably connected to each other by means of screw means.

11. A connection device according to one of the above claims, **characterized in that** electrical and/or electronic structural elements such as diodes are arranged on the printed circuit board (14).

12. A connection device for flat conductor ends according to claim 1, **characterized in that** the contacts for contacting the flat conductor ends can be taken off with the lid part (9) from the base part and the receiving unit (3).

## Revendications

1. Dispositif de raccordement pour des extrémités de conducteurs qui sont des extrémités de conducteurs plats (2) sur un panneau photovoltaïque (1) duquel dépassent plusieurs de ces extrémités de conducteurs (2), qui
a. comprend un boîtier de raccordement (7) avec un circuit électronique reçu dans le boîtier de raccordement (7) et
b. une unité de réception (3) pouvant être appliquée, en particulier collée, sur le panneau photovoltaïque afin de recevoir les extrémités de conducteurs (2) sur lesquelles le boîtier de raccordement (7) peut être posé,
c. dans lequel le boîtier de raccordement (7) est muni de contacts de raccordement (11) et
d. dans lequel les extrémités de conducteurs plats peuvent être mises en contact au moyen des contacts de raccordement (11) conducteurs électriques,
e. dans lequel l'unité de réception est conformée comme un support de réception (3) qui présente au moins un réception ou plusieurs réceptions, en particulier des barrettes de réception (4) par-dessus lesquelles une des extrémités de conducteur plat (2) peut être pliée et le boîtier de raccordement (7) peut être emboîté sur le support de réception (3), par exemple encliqueté, ce pour quoi il présente une face de fond ouverte au moins en partie afin de pouvoir être posé par-dessus le support de réception (3), et
f. dans lequel le boîtier de raccordement (7) présente une partie de base (8) et une partie formant couvercle (9), **caractérisée par** un circuit électronique fixé à la partie formant couvercle (9) qui peut être enlevé d'un bloc de la partie de base (8) avec la partie formant couvercle (9),
g. dans lequel le boîtier de raccordement (7) est muni de contacts à lames (11) ouverts en tulipe vers les barrettes de réception et servant de contacts de raccordement, qui ont pour fonction, lorsque le boîtier de raccordement (7) est posé sur le support de réception (3), de mettre en contact les extrémités de conducteur plat (2) pliées sur les barrettes de réception (4),
**caractérisé en ce que**
h. les contacts de raccordement (11) sont en outre conçus et disposés de façon à demeurer dans l'état mettant les extrémités de conducteur en contact sur le panneau photovoltaïque quand la partie formant couvercle est enlevée de la partie de base, et
i. **en ce que** les contacts de raccordement (11) sont conformés comme des doubles contacts avec des sens de mise en contact opposés.

2. Dispositif de raccordement pour des extrémités de conducteurs plats selon la revendication 1, **caractérisé en ce que** les contacts à lames (11) sont en forme de S dans un mode de réalisation préféré et forment un double contact à lames qui présente deux zones de contacts à lames (12, 13) ouvertes vers des côtés opposés.

3. Dispositif de raccordement selon la revendication 2, **caractérisé en ce que** les extrémités de conducteurs plats (2) peuvent être mises en contact avec l'une des zones de contacts à lames (12) en direction du panneau photovoltaïque et **en ce que** le circuit électronique, de préférence une zone de bord d'une carte de circuits imprimés (14), peut être mis en contact avec l'autre zone de contacts à lames (13) qui est ouverte sur le côté opposé par rapport à la première zone de contacts à lames (12).

4. Dispositif de raccordement pour des extrémités de conducteurs plats selon la revendication 3, **caractérisé en ce que** la carte de circuits imprimés (14) est fixée au couvercle (9), tandis que les contacts à lames (11) en forme de S sont fixés à la partie de base (8).

5. Dispositif de raccordement pour des extrémités de conducteurs plats selon l'une des revendications 3 ou 4, **caractérisé en ce que** les contacts à lames (11) en forme de S sont fixés sur la partie de base (8) à l'aide d'une barrette de maintien (16), de telle sorte que lorsque la partie formant couvercle (9) est détachée, cette partie formant couvercle (9) soit retirée des contacts à lames (11) avec la carte de circuits imprimés (14), tandis que les contacts à lames (11) restent sur le panneau photovoltaïque (1) avec la partie de base (8).

6. Dispositif de raccordement pour des extrémités de conducteurs plats selon l'une des revendications 4 à 5, **caractérisé en ce qu'**il est conçu de façon à permettre un échange de la carte de circuits imprimés (14) avec la partie formant couvercle (9) sans qu'il soit nécessaire de défaire le contact entre les extrémités de conducteurs plats (2) et les contacts à lames (11).

7. Dispositif de raccordement selon l'une des revendications précédentes, **caractérisé en ce que** des traversées latérales (14) sont formées sur le boîtier de raccordement (7) pour des câbles et des dispositifs d'enfichage (15).

8. Dispositif de raccordement selon l'une des revendications précédentes, **caractérisé en ce que** la partie de base (8) et la partie formant couvercle (9) sont reliées l'une à l'autre de manière amovible.

9. Dispositif de raccordement selon la revendication 8, **caractérisé en ce que** la partie de base (8) et la partie formant couvercle (9) sont reliées l'une à l'autre de manière amovible au moyen de moyens d'emboîtement.

10. Dispositif de raccordement selon la revendication 9, **caractérisé en ce que** la partie de base (8) et la partie formant couvercle (9) sont reliées l'une à l'autre de manière amovible au moyen de moyens de vissage.

11. Dispositif de raccordement selon l'une des revendications précédentes, **caractérisé en ce que** des composants électriques et/ou électroniques tels que des diodes sont disposés sur la carte de circuits imprimés (14).

12. Dispositif de raccordement pour des extrémités de conducteurs plats selon la revendication 1, **caractérisé en ce que** les contacts peuvent être enlevés de la partie de base et de l'unité de réception (3) pour la mise en contact des extrémités de conducteurs plats avec la partie formant couvercle (9).
